# EUROPEAN PATENT SPECIFICATION

(11) **EP 0 651 513 B1**
(45) Date of publication and mention of the grant of the patent: **06.08.1997**
(21) Application number: 93830437.5
(22) Date of filing: 29.10.1993
(51) Int. Cl.: H03K 19/173

(54) **Integrated circuit with bidirectional pin**
Integrierte Schaltung mit bidirektionnellem Anschlussstift
Circuit intégré avec borne bidirectionnelle

(43) Date of publication of application: 03.05.1995
(73) Proprietor: SGS-THOMSON MICROELECTRONICS s.r.l., 20041 Agrate Brianza (Milano) (IT)
(72) Inventor: Monti, Marco, I-20147 Milano (IT)
(74) Representative: Checcacci, Giorgio

(56) References cited:
- DE-A- 2 925 331
- JP-A- 1 256 212
- JP-A- 4 212 519
- JP-A- 4 262 440
- US-A- 4 752 700
- PATENT ABSTRACTS OF JAPAN vol. 7, no. 148 (E-184)29 June 1983 & JP-A-58 060 825

## Description

This invention relates to a semiconductor integrated circuit incorporating a two-way pin.

More specifically, the invention relates to an integrated circuit of the type which comprises at least one input terminal and at least one output terminal, respectively intended for receiving and transmitting digital and/or analog signals, said terminals being associated with discrete circuit portions of the integrated circuit implementing different logic functions, said terminals being coincident with a single pin, and with circuit means being arranged within the integrated circuit to detect the logic state of said pin.

As is well known, external connection pins provide the terminations for a package containing an electronic semiconductor integrated circuit. They enable such a package to be mounted in a quick-connect fashion on a carrier board at the same time as its electric connections are made.

A demand in this specific field of application is that the number of the external pins be minimized, to both bring down the package manufacturing costs and enhance the efficiency and reliability of the electronic device incorporated thereto.

However, this demand clashes with the integrated circuit designer own requirements, who is called upon to consolidate and implement a number of logic functions in the circuit, but would then have a limited number of pins available for communicating the circuit to the outside. Another problem with which the integrated circuit designer is confronted is that the circuit is also to meet the requirements of the packaging line of its manufacturer. It can be appreciated, therefore, that the current trend toward a decreased number of external pins adds to the designer's work.

For these reasons, the designer is seldom afforded a sufficient number of external pins to provide for all the functions he may seek, and is often to accept limitations on the circuit performance and/or potential for interfacing with external circuits connected to it.

Understandably, it would be desirable if a single pin could be made to serve multiple functions, but this has not been feasible heretofore lest disturbance or interaction might occur between functions.

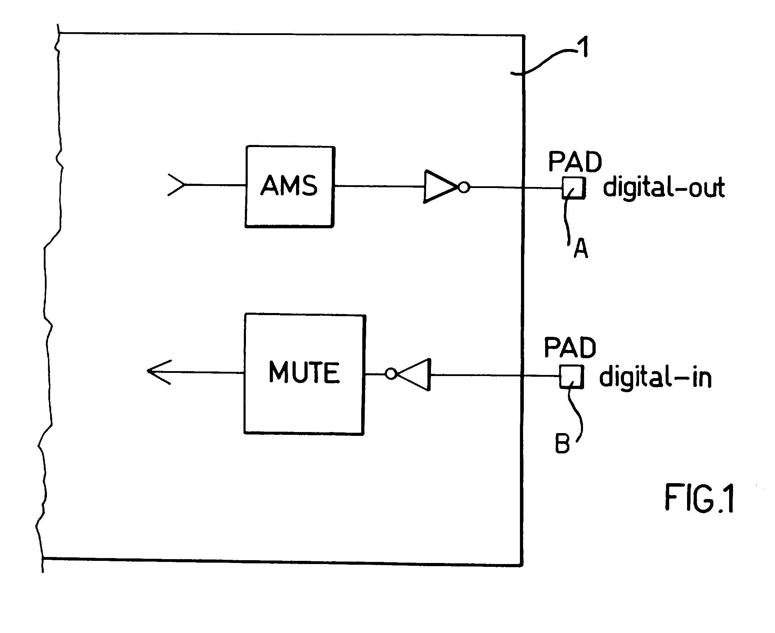

As an example, consider Figure 1 herein, which shows an integrated circuit having a first digital output pin A whereon a voltage value may be present which corresponds to either a logic low (0-2.5 volts) or a logic high (3.5-5 volts).

A second pin B is intended, on the other hand, to act as a digital or control input, and its state may either be one of open circuit or of grounded connection, for example.

Well, it is apparent that if the pins A and B were made to coincide, a control signal received on B would interfere with proper operation of the output A.

A prior art solution known from the Japanese patent aplication No. JP-A-04 212 519 discloses a two-way input buffer comprising one input terminal and one output terminal for receiving and transmitting digital signals respectively. Said terminals are associated with discrete circuit portions implementing different logic functions.

The terminals are coincident with a single pin 12 and circuit means are provided to detect the logic state of this single pin.

A similar solution is disclosed also in the Japanese patent applications No. JP-A-04 262 440 and No. JP-A-01 256 212.

These solutions, however, don't provide simple means to detect the state of said pin to facilitate the integration with a reduced IC area.

The underlying technical problem of this invention is to provide an improved integrated circuit which has such constructional and functional features as to overcome the limitations of prior approaches and allow a smaller number of external pins to be used.

More particularly, an object of the invention is to provide an integrated circuit having at least one two-way pin, i.e. a pin adapted for operation in a dual mode, as an output termination or input termination.

A further object of this invention is to arrange for at least two discrete circuit functions to be led to said one pin which have different (digital or analog) logic functionalities, and for the operability of one function to be unrelated to that of the other function.

The solutive idea on which this invention stands is to arrange for a single pin to serve as a digital output and digital input, and to have an electronic means detect the logic state of the pin.

Based on the above solutive idea, the technical problem is solved by an integrated circuit as previously indicated and defined in the characterizing parts of the appended claims.

The features and advantages of a circuit according to the invention will be apparent from the following description of an embodiment thereof, given by way of example and not of limitation with reference to the accompanying drawings.

In the drawings:
- Figure 1 is a diagram showing a portion of a prior art integrated circuit;

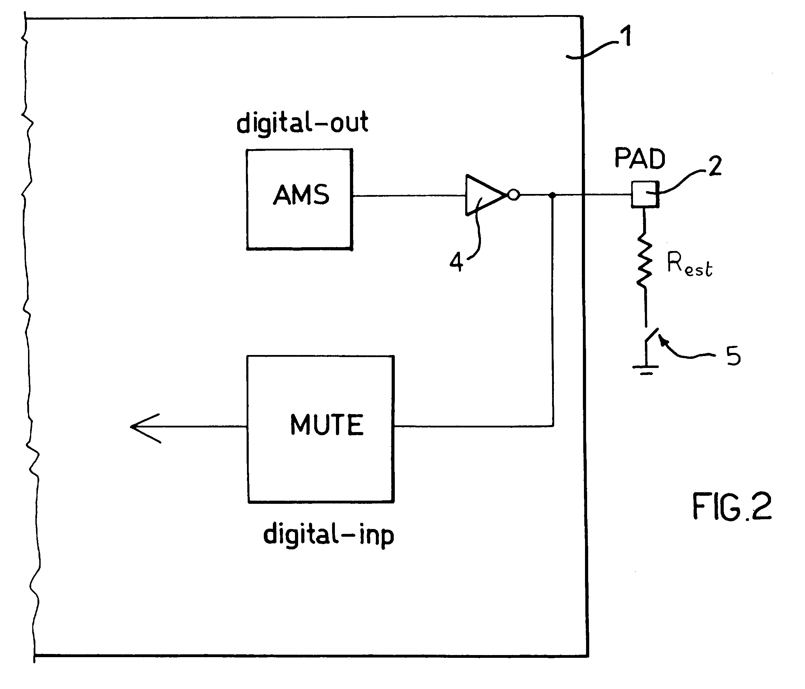

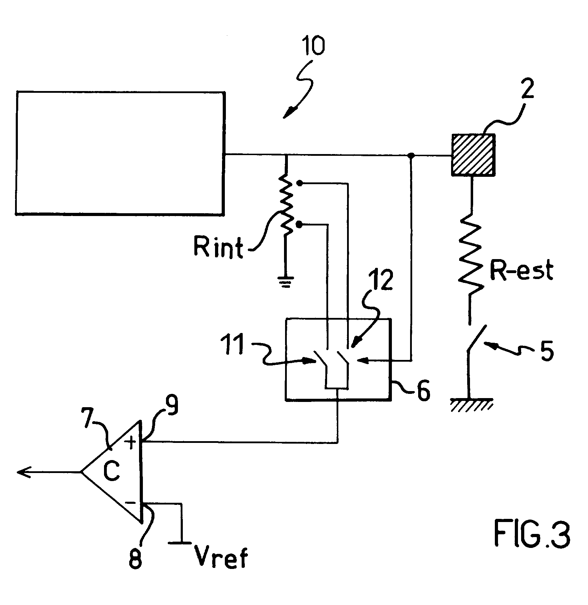

- Figure 2 is a diagram showing a detail of an integrated circuit embodying this invention; Figure 3 is a diagram showing the detail of Figure 2 more clearly; and
- Figure 4 is a diagram illustrating an embodiment of the circuit in Figure 3.

With reference to the drawing Figures, generally and schematically shown at 1 is a semiconductor integrated circuit including a dual-function, two-way external pin 2 in accordance with the invention. The circuit 1 may be. for example, an audio device known by the trade name of TDA 7337, from this Applicant's range.

The pin 2 is connected, via an inverter 4, to the output of a first circuit portion marked AMS (Automatic Music Sensor) and consistent with the typical threshold voltage levels of CMOS technologies, meaning that the voltage value supplied on that output is in the 0 to 5-volt range. The pin 2 is also connected to the input of a second circuit portion marked MUTE and intended to activate and deactivate the "mute" function of the audio circuit.

Also in accordance with the invention, it would be possible to connect the pin to another circuit portion intended for implementing another function, e.g. enabling the "standby" function of the audio circuit.

Externally of the circuit 1, the pin 2 is connected to a signal ground via a resistance Rest whose value is known and selected preferably to be 40 kohms. Connected serially between the resistance Rest and ground is also a normally open microswitch 5 provided either by an external open-collector circuit or a gate of a microprocessor.

The voltage level on the pin 2 defines the logic state of the digital output.

When the switch 5 is closed by grounding the external resistance Rest, the voltage applied to the pin 2 will represent the logic state of a control input, and accordingly, provide the corresponding digital command to the digital input function.

Advantageously, according to the invention, a circuit means 10 is provided within the circuit 1 to detect the logic state of the pin 2 and locate its operative functions as digital output or digital input, respectively.

The circuit means 10 comprises a comparator 7 having a first inverting input 8 at which a reference voltage Vref is held, and a second non-inverting input 9 connected to the output of an actuator block 6.

The block 6 comprises at least a pair of normally open electronic switches 11 and 12 which are tied operatively to the voltage value present on the pin 2. That is, the voltage signal at the pin 2 is picked up and transmitted to the actuator block 6 to allow the switches 11 and 12 to be driven.

An impedance Rint, internal of the circuit 1, is connected between the pin 2 and ground, and allows variations in the voltage value appearing on the pin 2 to be detected.

The switches 11 and 12 parallel connect the opposing ends of the internal impedance Rint respectively to the non-inverting input 9 of the comparator 7.

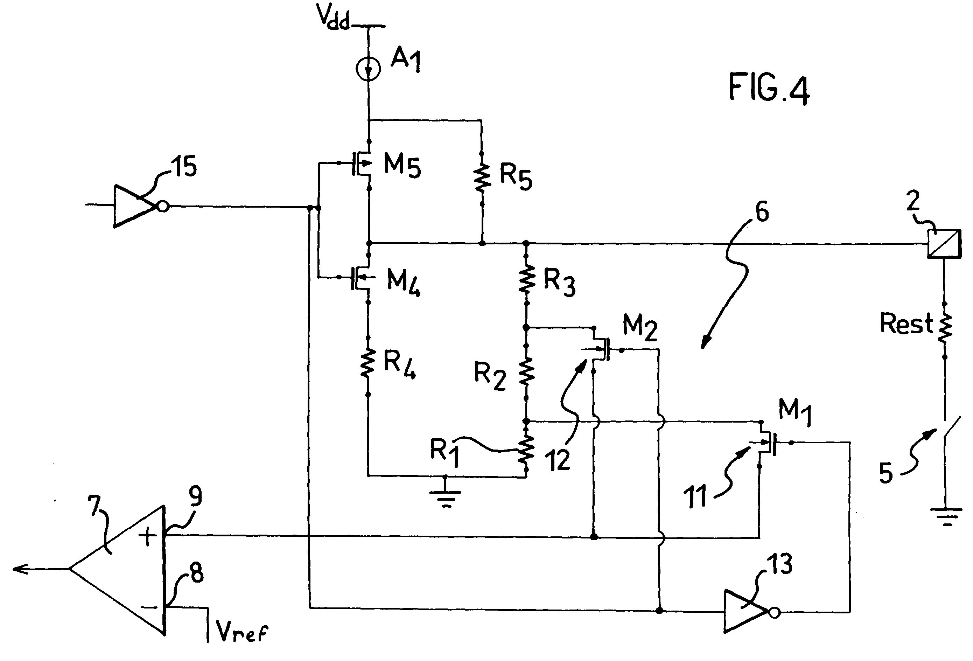

The construction of the circuit means 10 incorporated to the inventive circuit 1 will now be described in further detail with specific reference to the embodiment shown in Figure 4.

The internal resistance Rint is comprised of a set of resistors R1, R2 and R3 connected in series between a signal ground and the pin 2. Preferably, these resistors have values of 6, 30, and 6 kohms.

The first resistor, R1, has one end connected to ground and the other end connected to the drain terminal of a first field-effect transistor M1, preferably of the MOS type, as well as to the resistor R2. That transistor M1 has its source terminal connected to the non-inverting input 9 of the comparator 7 and to the source terminal of a second MOS transistor M2.

This second transistor M2 has its drain terminal connected between the second R2 and third R3 resistors, and its gate terminal connected to the input of an inverter 13 whose output is connected to the gate terminal of the first transistor M1.

The two transistors, M1 and M2, perform basically the same functions as the two switches 11 and 12 of the previous arrangement.

The three resistors R1, R2 and R3 are parts of a network 14 which also includes a fourth resistor R4 and a third MOS transistor M3. The resistor R4, of about 40 kohms, is connected between ground and the source of the transistor M3 having its drain terminal connected to the pin 2.

The gate terminal of the transistor M4 is in common with the gate terminal of a fifth transistor M5 which is further connected to the former by the coupling of the respective source and drain terminals. A biasing resistor R5 of about 120 kohms is connected between the drain and the source of the fifth transistor M5, while a current generator A1 connects a positive 8-volt supply voltage pole Vdd to the drain of the transistor M5.

An inverter 15 has its output connected to the gate terminals of the transistors M4 and M5 and to the gate of the transistor M2.

The operation of the inventive circuit is quite straightforward, and will be discussed in relation to four different possible conditions of its operation.

By operating the microswitch 5, a change is produced in the internal impedance Rint dependent on whether the internal resistance Rest is connected or unconnected to ground.

The change in the internal impedance is detected by the comparator 7 by means of a current/voltage conversion. Thus, the comparator 7 will change the logic state of its output U and send a control signal to the internal circuitry of the IC 1.

It should be further noted that the change in internal impedance brings about a change in the voltage value present on the pin 2. In particular, the voltage will drop as the external resistance is connected to ground.

Understandably, it will be necessary to arrange for this change to occur within a range of values consistent with the conditions for MOS technology circuit operation.

However, the connection of the external resistance causes no change to occur in the logic state of the output pin 2.

The operation of the circuit according to the invention is worth reviewing in the light of the embodiment shown in Figure 4. Four different conditions of its operation can be discerned which will be analyzed herein below.
1) A high output voltage value with the resistance Rest unconnected to ground.
   In this case, the first transistor M1 would be on and the other transistor M2 off. The current from the generator A1 is caused to flow, via the transistor M5, through the resistors R3, R2 and R1.
   The value of this current is such that the voltage value transferred to the input 9 of the comparator 7 from the transistor M1 is higher than the threshold value Vref. Thus, the comparator output U will be at a logic high substantially equal to A1∗(R1+R2+R3) . The voltage value at the pin 2 will also be high but consistent with voltage values as are typical of CMOS technology.
2) A high output voltage value with the external resistance connected to ground. This case is similar to the previous one, except that the external resistance Rest causes the current flowing through the series of R1, R2 and R3 to decrease. Therefore, the voltage value at the comparator input 9 will be inadequate to switch the comparator over.
   As against the previous case, the voltage at the comparator output U will be at a logic low and dependent on the parallel between the resistors R1, R2 and R3 and the external resistance Rest. By appropriate selection of the resistive values, it becomes possible to keep within the the range of CMOS consistency for the digital thresholds.
   The pin 2 will at all times be held at a logic high equal to A1∗[(R1+R2+R3)//Rest] ; thus, the connection of the external resistance may be said to only have caused a change in the voltage value at the comparator output U.
3) A low output voltage value with the resistance unconnected.
   The current A1 flows through the resistors R3, R2 and R1, as well as through the resistor R5. The transistor M2 is on, whereas the transistor M1 is off.
   The voltage at the comparator input 9, which is connected to the resistor R2, is higher than the reference threshold Vref, and the output U of the comparator 7 will be at a logic high.
   However, the voltage value at the pin 2 will be low, and equal to A1∗[(R1+R2+R3)//R4] because of the parallel between the series resistors R1, R2 and R3, and the resistor R4.
4) A low output voltage value with the resistance connected.
   Some of the current from the generator A1 is redirected toward the external resistance Rest connected to ground.
   The voltage present on the input 9 of the comparator 7 is lower than the threshold Vref, and the output U will be at a logic low. The voltage at the pin 2 will be fixed by the parallel of the resistor R4, the external resistance Rest, and the series of R1, R2 and R3.

Therefore, the voltage at the pin 2 will be different from that of case (3) above, but still at a logic low and consistent with the CMOS technology circuits after it.

Basically, upon the external resistance being connected to ground, a change is caused to occur in the logic state of the single comparator without the logic value at the output pin 2 being altered. The voltage value present on the pin 2 varies slightly according to whether the external esistance is connected, but this variation is tolerable within consistent values with CMOS technologies.

Inasmuch as the connection of the external resistance represents a control signal received on the pin 2, it may also be seen that the pin 2, although operated as a control input, would undergo no alteration of its logic value when functioning as an output termination.

The integrated circuit of this invention does solve the technical problem and affords a number of advantages, outstanding among which is undoubtedly the fact that a single pin can now be used to serve two discrete digital functions that would otherwise require two different control pins if embodied as in the prior art. The two functions using the same pin are wholly independent of each other and retain CMOS consistency for the value of the output logic state. Thus, the digital command on the pin 2 will be unrelated to the digital output function served by that pin.

Advantageously, the inventive circuit could be applied to the measurement of variations in the output voltage from a digital output, following connection of an external impedance of known value.

Many changes and modifications may be made unto the circuit described hereinabove within the scope of the invention as defined by the appended claims. In particular, the inventive circuit could be provided with a delay circuit to avoid switching spikes.

The comparator 7 could be embodied by a single bipolar of the npn type, and the STANDBY function could be substituted for the digital control MUTE function.

## Claims

1. An integrated circuit of the type which comprises at least one input terminal and at least one output terminal, respectively intended for receiving and transmitting digital and/or analog signals, said terminals being associated with discrete circuit portions of the integrated circuit implementing different logic functions, said terminals being coincident with a single pin (2), and circuit means (10) being arranged within the integrated circuit (1) to detect the logic state of said pin (2)
characterized in that said means (10) comprises comparator means (7) connected to and cooperating with an internal impedance (Rint) of the circuit (1), said impedance being connected between the pin (2) and ground, to detect changes in the voltage value present on said pin by comparison with a reference voltage (Vref).

2. An integrated circuit according to Claim 1, characterized in that said comparator means comprises a comparator (7) having a first input (8), on which said reference voltage (Vref) is maintained, and a second input (9) connected to one end of said internal impedance (Rint).

3. An integrated circuit according to Claim 2, characterized in that said second comparator input (9) is connected to the output of an actuator block (6) incorporating at least a pair of normally open electronic switches (11,12) linked operatively to the voltage value present on the pin (2), and that said switches (11,12) connect opposing taps of the internal impedance (Rint) to the input (9) of the comparator (7).

4. An integrated circuit according to Claim 3, characterized in that said switches (11,12) are field-effect transistors (M1,M2).

5. An integrated circuit according to Claim 2, characterized in that said internal impedance (Rint) comprises a set of resistors (R1,R2,R3) connected in series.

6. An integrated circuit according to Claim 5, characterized in that said set comprises at least three resistors (R1,R2,R3).

7. An integrated circuit according to Claim 1, characterized in that it is associated with an external resistance (Rest) connected between the pin (2) and a signal ground via a microswitch (5).

## Patentansprüche

1. Integrierte Schaltung vom Typ mit mindestens einem Eingangsanschluß und mindestens einem Ausgangsanschluß zum Empfangen bzw. Abgeben digitaler und/oder analoger Signale, wobei die Anschlüsse zu diskrekten Schaltungsabschnitten der integrierten Schaltung gehören, die unterschiedliche logische Funktionen implementieren, und die Anschlüsse sich einen einzigen Anschlußstift (2) teilen, und innerhalb der integrierten Schaltung (1) eine Schaltungseinrichtung (10) zum Nachweisen des logischen Zustands des Stifts (2) ausgebildet ist,
dadurch gekennzeichnet, daß die Einrichtung (10) eine Vergleichereinrichtung (7) aufweist, die an eine interne Impedanz (Rint) der Schaltung (1) angeschlossen ist und mit dieser zusammenarbeitet, wobei die Impedanz zwischen den Stift (2) und Masse geschaltet ist, um Änderungen des Spannungswerts an dem Stift durch Vergleich mit einer Referenzspannung (Vref) nachzuweisen.

2. Integrierte Schaltung nach Anspruch 1,
dadurch gekennzeichnet, daß die Vergleichereinrichtung aufweist: einen Vergleicher (7) mit einem ersten Eingang (8), an dem die Referenzspannung (Vref) anliegt, und einem zweiten Eingang (9), der an einem Anschluß der internen Impedanz (Rint) angeschlossen ist.

3. Integrierte Schaltung nach Anspruch 2,
dadurch gekennzeichnet, daß der zweite Vergleichereingang (9) an den Ausgang eines Betätigungsblocks (6) angeschlossen ist, der mindestens ein Paar normalerweise offener elektronischer Schalter (11, 12) beinhaltet, die betrieblich mit dem an dem Stift (2) anstehenden Spannungswert gekoppelt sind, und daß die Schalter (11, 12) entgegengesetzte Abgriffe der internen Impedanz (Rint) mit dem Eingang (9) des Vergleichers (7) verbinden.

4. Integrierte Schaltung nach Anspruch 3,
dadurch gekennzeichnet, daß die Schalter (11, 12) als Feldeffekttransistoren (M1, M2) ausgebildet sind.

5. Integrierte Schaltung nach Anspruch 2,
dadurch gekennzeichnet, daß die interne Impedanz (Rint) einen Satz von Widerständen (R1, R2, R3) aufweist, die in Reihe geschaltet sind.

6. Integrierte Schaltung nach Anspruch 5,
dadurch gekennzeichnet, daß der Satz mindestens drei Widerstände (R1, R2, R3) beinhaltet.

7. Integrierte Schaltung nach Anspruch 1,
dadurch gekennzeichnet, daß ihr ein externer Widerstand (Rest) zugeordnet ist, der über einen Mikroschalter (5) zwischen den Stift (2) und Signal-Masse gelegt ist.

## Revendications

1. Circuit intégré du type comprenant au moins une borne d'entrée et au moins une borne de sortie, destinées respectivement à recevoir et à transmettre des signaux numériques et/ou analogiques, lesdites bornes étant associées à des portions de circuit discrètes du circuit intégré mettant en oeuvre différentes fonctions logiques, lesquelles bornes correspondent à une broche unique (2), et des moyens de circuiterie (10) étant prévus à l'intérieur du circuit intégré (1) pour détecter l'état logique de ladite broche (2),
caractérisé en ce que lesdits moyens (10) comprennent des moyens de comparaison (7) connectés et coopérant avec une impédance interne (Rint) du circuit (1), ladite impédance étant connectée entre la broche (2) et la masse, pour détecter les changements de valeurs de la tension présente sur ladite broche par comparaison avec une tension de référence (Vref).

2. Circuit intégré selon la revendication 1, caractérisé en ce que lesdits moyens de comparaison comprennent un comparateur (7) ayant une première entrée (8) sur laquelle est maintenue ladite tension de référence (Vref), et une seconde entrée (9) connectée à une extrémité de ladite impédance interne (Rint).

3. Circuit intégré selon la revendication 2, caractérisé en ce que ladite seconde entrée (9) du comparateur est connectée à la sortie d'un bloc actionneur (6) comprenant au moins une paire d'interrupteurs électroniques (11,12) ouverts en conditions normales et couplés en fonctionnement à la valeur de tension présente sur la broche (2) et en ce que lesdits interrupteurs (11,12) sont connectées aux pattes opposées de l'impédance interne (Rint) à l'entrée (9) du comparateur (7).

4. Circuit intégré selon la revendication 3, caractérisé en ce que lesdits interrupteurs (11,12) sont des transistors à effet de champ (M1,M2).

5. Circuit intégré selon la revendication 2, caractérisé en ce que ladite impédance interne (Rint) comprend un ensemble de résistances (R1,R2,R3) connectées en série.

6. Circuit intégré selon la revendication 5, caractérisé en ce que ledit ensemble comprend au moins trois résistances (R1,R2,R3).

7. Circuit intégré selon la revendication 1, caractérisé en ce qu'il est associé à une résistance externe (Rest) connectée entre la broche (2) et la masse par l'intermédiaire d'un micro-interrupteur (5).
